(19) Europäisches Patentamt
European Patent Office
Office européen des brevets

(11) EP 2 708 862 B1

(12) FASCICULE DE BREVET EUROPEEN

(45) Date de publication et mention
de la délivrance du brevet:
**19.08.2020 Bulletin 2020/34**

(51) Int Cl.:
*G01J 9/00* *(2006.01)*

(21) Numéro de dépôt: **13182218.1**

(22) Date de dépôt: **29.08.2013**

(54) **Instrument d'optique à analyseur de front d'onde**

Optischer Wellenfrontanalysator

Optical wavefront analyser

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **14.09.2012 FR 1202452**

(43) Date de publication de la demande:
**19.03.2014 Bulletin 2014/12**

(73) Titulaire: **Thales
92400 Courbevoie (FR)**

(72) Inventeurs:
• **Liotard, Arnaud
06130 GRASSE (FR)**
• **Bernot, Marc
06150 CANNES LA BOCCA (FR)**
• **Falzon, Frédéric
06580 PEGOMAS (FR)**
• **Perrin, Guillaume
69160 Tassin la Demi Lune (FR)**

(74) Mandataire: **Honnet, Sylvie Florence Liliane et al
Marks & Clerk France
Immeuble Visium
22, avenue Aristide Briand
94117 Arcueil Cedex (FR)**

(56) Documents cités:
**CN-A- 102 564 612    CN-A- 102 636 271
US-A- 5 610 707**

**Description**

Le domaine général de l'invention est celui des instruments d'optique comportant des moyens d'analyse du front d'onde. Un des principaux domaines d'application est la réalisation de télescopes spatiaux.

Un instrument d'optique spatial ou un télescope spatial comporte un système optique de focalisation comportant généralement plusieurs miroirs et un dispositif d'analyse d'image comportant des moyens de photoréception et des moyens informatiques permettant d'assurer le traitement des images reçues. Les moyens de photoréception peuvent être soit une matrice de photorécepteurs, soit un ensemble comportant une ou plusieurs lignes de barrettes de photorécepteurs. Dans ce cas, l'instrument comporte des moyens opto-mécaniques assurant le balayage de l'image.

Quelque soit la configuration retenue, il est clair que l'on cherche à obtenir les images les plus précises possibles. Or, les instruments d'optique ne sont capables que de mesurer une intensité lumineuse et l'information de phase de l'image est donc perdue. Par exemple, dans un système optique à balayage, les données acquises dans la direction x des lignes de barrettes et notées {d(x)} sont des mesures bruitées de la convolution de l'objet observé, s'écrivant $o(x,\lambda)$ à une longueur d'onde λ, avec la réponse percussionnelle du système optique ou « PSF », acronyme de « Point Spread Function », et notée $h(x,\lambda)$, intégrée sur la bande spectrale d'intensité $f(\lambda)$ de la voie d'acquisition .

On a ainsi la relation 1 :

$$\text{Relation 1 : } d\big(x\big) = N\Big[h*o\big(x\big)\Big] = N\left[\int_{\lambda}\big(h\big(x,\lambda\big)*o\big(x,\lambda\big)\big)f\big(\lambda\big)d\lambda\right]$$

La qualité optique de l'instrument est caractérisée par une erreur de phase du front d'onde, encore appelée en terminologie anglo-saxonne « WFE », acronyme signifiant « Wave-Front Error ». Cette WFE prend en compte les aberrations des miroirs du télescope, mais également les différents défauts d'alignement des miroirs constituant le télescope ou du détecteur par rapport au télescope. L'information de la WFE est « contenue » dans la PSF optique du système notée $h^{OPT}(x,\lambda)$, la PSF globale étant égale à la convolution de cette dernière avec d'autres composantes liées à la qualité du détecteur, aux bougés,...On a ainsi la relation 2 :

$$\text{Relation 2 : } h^{\text{OPT}}\big(x,\lambda\big) = \left|TF^{-1}\Big[A\big(p\big)e^{i\varphi(p,\lambda)}\Big]\left(\frac{x}{\lambda F}\right)\right|^2$$

où $A(p)$ et $\varphi(p,\lambda)$ sont respectivement l'amplitude et la phase du champ au niveau de la pupille de l'instrument, F étant la focale de l'instrument.

Une estimation de la WFE est essentielle dans la mesure où sa connaissance permet de corriger tout ou partie des défauts de l'instrument pour retrouver une image la plus propre possible de l'objet. Elle requiert la mise en place d'un dispositif dédié. Cette connaissance est indispensable lorsque l'instrument est actif, c'est-à-dire qu'il possède des moyens permettant de corriger la forme ou l'alignement des miroirs de façon à garder constamment une image qui soit la plus nette possible.

Il existe différentes solutions d'analyse de front d'onde permettant de retrouver la WFE. Généralement, on classe les analyseurs en deux familles, qui sont les analyseurs dits « plan pupille » et les analyseurs dits « plan focal ».

Parmi les analyseurs plan pupille, on notera principalement la méthode de Shack-Hartmann qui consiste à échantillonner la pupille d'entrée et à imager dans une voie dédiée l'ensemble des scènes observées, afin de mesurer localement la WFE. L'inconvénient d'une telle approche est l'utilisation d'une partie du flux d'entrée pour une voie d'analyse « annexe » ainsi que la complexité du dispositif optique à mettre en place.

Les analyseurs plan focal ne disposent pas de tels inconvénients, puisqu'ils consistent à utiliser des acquisitions réalisées au niveau du plan focal de l'instrument pour estimer le front d'onde. Une façon de traiter ce problème est, par exemple, d'acquérir deux images de la même scène o(x), l'une étant défocalisée par rapport à l'autre et d'utiliser un algorithme de type diversité de phase. La diversité de phase peut être utilisée à des fins de restauration d'image, le but est alors de trouver o(x) , ou à des fins d'analyse de front d'onde, le but est dans ce cas de trouver la WFE $\varphi(p)$, la WFE étant généralement paramétrée comme une combinaison linéaire de vecteurs de Zernike représentatifs du défaut de focalisation ou des aberrations géométriques comme l'astigmatisme.

Les analyses par la diversité de phase permettent donc de déterminer la WFE du télescope à partir d'acquisitions d'images. Cette information de phase peut être utilisée dans un système d'optique active pour le corriger en boucle fermée, ou bien a posteriori pour restaurer les données acquises et ainsi améliorer la qualité image.

De très nombreux articles ont été publiés, depuis près de 30 ans, sur l'analyse de front d'onde par la diversité de phase et les applications spatiales de cette analyse. La grande majorité propose diverses approches algorithmiques pour résoudre ce problème, d'autres décrivent son application à des missions particulières lorsque l'objet est connu et ponctuel. On parle alors de restitution de phase.

On citera notamment l'article de Gonsalves intitulé « Phase retrieval and diversity in adaptive optics », Optical Engineering, 21, 1982 qui est considéré comme l'article fondateur sur la diversité de phase.

On citera aussi l'article de Paxman intitulé « Joint estimation of object and aberrations by using phase diversity », Journal of the Optical Society of America A, 9(7), 1992 qui fait référence et qui présente l'approche algorithmique la plus couramment utilisée.

On citera encore l'article de Fienup intitulé « Hubble space telescope characterized by using phase retrieval algorithms », Applied Optics, 32(10):1747-1767, 1993; celui de Löfdahl intitulé « Wavefront sensing and image restoration from focused and defocused solar images», Astronomy and Astrophysics, 107:243-264, 1994 et enfin celui de Dean intitulé « Phase retrieval algorithm for JWST flight testbed telescope, Space telescopes and Instrumentation », SPIE 6265, 2006 qui présentent des applications de la diversité de phase à des cas concrets comme l'étude des taches solaires, le réglage du télescope Hubble ou « HST » pour Hubble Space Telescope » ou celui du télescope « JWST » signifiant « James Webb Space Telescope ».

L'article de Kendrick intitulé « Closed-loop wavefront correction using phase diversity », SPIE 3356 Space Telescopes and Instruments, 1998 décrit une approche en boucle fermée, avec quelques designs architecturaux de capteurs de diversité de phase.

Enfin, l'article de Luke intitulé « Optical wavefront reconstruction: theory and numerical methods », SIAM review 44(2):169-224, 2002 présente un état de l'art des différentes approches algorithmiques.

Des brevets ont été également déposés sur l'analyse du front d'onde soit sur l'algorithme de diversité de phase, soit sur les moyens de créer simplement les défocalisations nécessaires à cet algorithme de diversité de phase.

On citera notamment le brevet US 4,309,602 intitulé « Wavefront sensing by phase retrieval » qui décrit l'approche algorithmique et le cadre de l'utilisation d'une boucle capteur-analyse de front d'onde-optique adaptative.

On citera également le brevet US 5,598,261 intitulé « Wavefront sensor for a scanning imager » qui présente un concept en « TDI » pour « Time Delay Intégration » comportant deux détecteurs parallèles, le second étant défocalisé par rapport au premier par l'apport d'un substrat transparent. Il peut s'agir de défocalisations ajoutées sur toute ou portion de la longueur du détecteur ou bien au niveau de zones inter-barrettes.

On citera aussi le brevet US 5,610,707 intitulé « Wavefront sensor for a staring imager» qui présente un concept similaire au précédent mais adapté à un capteur matriciel avec utilisation d'un séparateur de faisceau pour obtenir les images focalisée et défocalisée.

On citera la demande US 2004/0099787A1 intitulée «System and method for determining optical aberrations in scanning imaging systems by phase diversity» qui présente un concept en TDI comportant deux rangées parallèles de détecteur, l'une d'elle, potentiellement composée de plusieurs éléments, étant décalée le long de l'axe optique par rapport à l'autre pour défocaliser l'image.

Les brevets US 2004/0056174 intitulé « Fast phase diversity wavefront correction using a neural network » et FR 2919052 intitulé « Procédé d'estimation d'au moins une déformation du front d'onde d'un système optique ou d'un objet observé par le système optique et dispositif associé » présentent une adaptation de la partie algorithmique à des besoins de calcul rapide.

Enfin, le brevet US 7,274,442 intitulé «Closed loop wavefront sensor using field programmable gate array» présente une approche architecturale du traitement algorithmique à bord, combinant l'utilisation de capteurs de diversité de phase et de FPGAs. Les documents CN102564612 A et CN102636271 A divulguent aussi des instruments d'optique comportant des moyens d'analyse du front d'onde.

L'objet du dispositif selon l'invention, qui est décrit dans la revendication 1, est de proposer des adaptations opto-mécaniques d'un système optique, notamment un télescope, permettant de créer simplement les défocalisations nécessaires à un algorithme de diversité de phase.

Plus précisément, l'invention a pour objet un instrument d'optique comprenant au moins :

une architecture optique comprenant un ensemble optique destiné à faire d'un objet lumineux une image,
un ensemble de photoréception et des moyens d'acquisition et d'analyse de ladite image, lesdits moyens d'acquisition et d'analyse comportant un algorithme de type diversité de phase,
caractérisé en ce que l'architecture optique comporte une lame optique de puissance optique faible ou nulle disposée au voisinage de l'ensemble de photoréception et agencée de façon à former sur tout ou partie dudit ensemble une première image focalisée et une seconde image défocalisée d'une première valeur prédéterminée et décalée d'une seconde valeur prédéterminée par rapport à la première image.

Avantageusement, l'instrument ayant un axe optique, la lame optique est une lame à faces planes, parallèles entre elles et perpendiculaires à l'axe optique, la première image étant obtenue en transmission simple à travers ladite lame optique, la seconde image étant obtenue en transmission après double réflexion sur les deux faces de la lame, la lame optique étant située préférentiellement au bord de l'ensemble de photoréception.

Avantageusement, l'instrument ayant un axe optique, la lame optique est une lame à faces planes et parallèles inclinée sur l'axe optique, la première image étant obtenue en transmission simple à travers ladite lame optique, la seconde image étant obtenue en transmission après double réflexion sur les deux faces de la lame.

Avantageusement, la lame optique est un prisme à faces planes, la première image étant obtenue en transmission simple à travers ledit prisme, la seconde image étant obtenue en transmission après double réflexion sur les deux faces dudit prisme.

Avantageusement, la lame optique est une lame d'air dont les faces sont d'une part la face d'entrée de l'ensemble de photoréception et d'autre part une des faces d'une fenêtre de protection disposée devant ledit ensemble de photoréception, la première image étant obtenue en transmission simple à travers ladite fenêtre de protection, la seconde image étant obtenue en transmission après double réflexion sur la face d'entrée de l'ensemble de photoréception et sur la face de la fenêtre de protection.

Avantageusement, la lame optique est un miroir de Mangin, c'est-à-dire une lame optique comportant une première face semi-réfléchissante et une seconde face réfléchissante, la première image étant obtenue par réflexion sur la première face semi-réfléchissante, la seconde image étant obtenue par réflexion sur la seconde face réfléchissante.

Avantageusement, la lame optique comporte un ou deux traitements réfléchissants de façon que l'amplitude de la première image focalisée soit du même ordre de grandeur que l'amplitude de la seconde image défocalisée.

Avantageusement, l'instrument d'optique est un télescope spatial.

L'invention sera mieux comprise et d'autres avantages apparaîtront à la lecture de la description qui va suivre donnée à titre non limitatif et grâce aux figures annexées parmi lesquelles :

La figure 1 représente un premier mode de réalisation de la lame optique selon l'invention ;
La figure 2 représente une variante de ce premier mode de réalisation de la lame optique selon l'invention ;
La figure 3 représente un second mode de réalisation de la lame optique selon l'invention ;
La figure 4 représente les intensités respectives de la première image et de la seconde image obtenues par passages à travers la lame optique du premier et du second mode de réalisation ;
La figure 5 représente un troisième mode de réalisation de la lame optique selon l'invention ;
La figure 6 représente les intensités respectives de la première image et de la seconde image obtenues par passages à travers la lame optique du troisième mode de réalisation.

L'objet de l'invention est d'introduire, dans l'architecture optique d'un système optique, une lame optique permettant de créer simplement les défocalisations nécessaires à un algorithme de diversité de phase. L'invention s'applique tout particulièrement au domaine des télescopes et plus précisément au domaine des télescopes spatiaux.

Il existe différentes dispositions possibles permettant d'obtenir le résultat recherché.

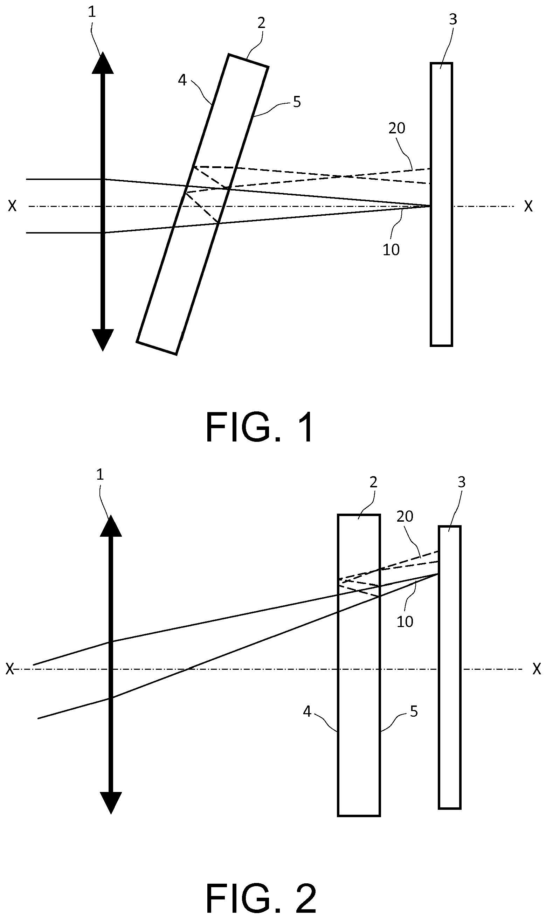

A titre d'exemples non limitatifs, les figures 1 à 6 proposent quatre modes de réalisation différents. Dans chacun de ces différents modes, la lame optique couvre tout le champ du capteur. Bien entendu, selon les applications, elle peut n'en couvrir qu'une partie dédiée à l'analyse d'image.

Sur ces figures, l'architecture optique est réduite à une lentille de focalisation 1. Dans le cas général, cette architecture est sensiblement plus complexe et comporte généralement plusieurs miroirs. De la même façon, sur ces figures, la lame optique 2 est le dernier élément optique situé juste avant l'ensemble de photoréception 3. Il est possible d'envisager d'autres configurations. Sur les différentes figures, les éléments 1, 2 et 3 sont représentés en traits gras et les rayons lumineux en traits fins. L'axe optique X-X de la lentille 1 est représenté en traits pointillés. Sur ces différentes figures, l'objet lumineux initial dont la lentille de focalisation 1 donne une image n'est pas représenté. Dans le cas général, l'objet est à grande distance et on considère qu'il est optiquement à l' « infini ».

Dans une première configuration représentée en figure 1, la lame optique 2 est une lame à faces planes et parallèles inclinée sur l'axe optique X-X. Cette lame donne deux images 10 et 20 sur le capteur 3. La première image 10 est obtenue par transmission à travers la lame optique 2, la seconde image est obtenue après double réflexion sur les deux faces 4 et 5 de la lame optique. Cette seconde image 20 est décalée et défocalisée par rapport à la première image 10. Sur la figure 1, l'image 10 est focalisée et l'image 20 est défocalisée. On peut, bien entendu, adopter la configuration inverse, c'est-à-dire focaliser l'image 20 et défocaliser l'image 10. Il suffit de déplacer le plan de réception du photorécepteur.

Les valeurs du décalage et de la défocalisation dépendent de l'épaisseur de la lame, de son indice optique, de son inclinaison et de la géométrie des faisceaux lumineux et sont facilement calculables. Ainsi, en bord de champ, les faisceaux lumineux peuvent être suffisamment inclinés pour que la lame optique puisse être perpendiculaire à l'axe optique X-X comme on le voit sur la figure 2. Cette lame introduit des aberrations géométriques et en particulier de l'astigmatisme que l'on peut compenser soit en tenant compte dans le calcul de l'architecture optique, soit en donnant une forme particulière à la lame optique.

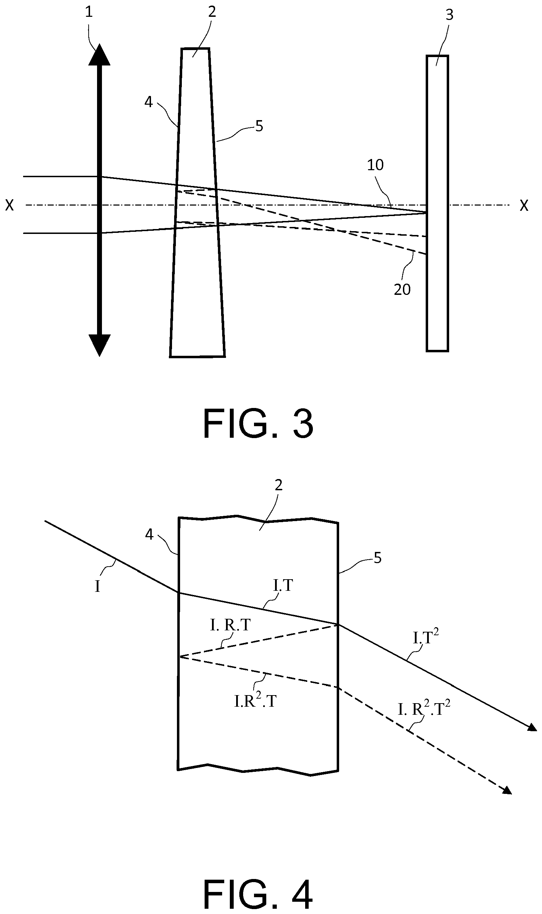

Dans une seconde configuration représentée en figure 3, la lame optique 2 est un prisme à faces planes sensiblement, perpendiculaire à l'axe optique X-X. Cette lame donne également deux images 10 et 20 sur le capteur 3. La première image 10 est obtenue par transmission à travers la lame optique 2, la seconde image est obtenue après double réflexion sur les deux faces 4 et 5 de la lame optique. Cette seconde image 20 est décalée et défocalisée par rapport à la première image 10. Les valeurs du décalage et de la défocalisation dépendent de l'épaisseur de la lame, de son indice optique, de l'angle du prisme et de la géométrie des faisceaux lumineux. Cette lame introduit des aberrations chromatiques que l'on peut compenser soit en tenant compte dans le calcul de l'architecture optique, soit en utilisant un prisme composé de deux lames prismatiques disposées tête-bêche et corrigées du chromatisme.

Dans une variante des deux configurations précédentes, on peut utiliser une lame d'air dont les faces sont d'une part la face d'entrée de l'ensemble de photoréception et d'autre part une des faces d'une fenêtre de protection disposée devant ledit ensemble de photoréception, la première image étant obtenue en transmission simple à travers ladite fenêtre de protection, la seconde image étant obtenue en transmission après double réflexion sur la face d'entrée de l'ensemble de photoréception et sur la face de la fenêtre de protection.

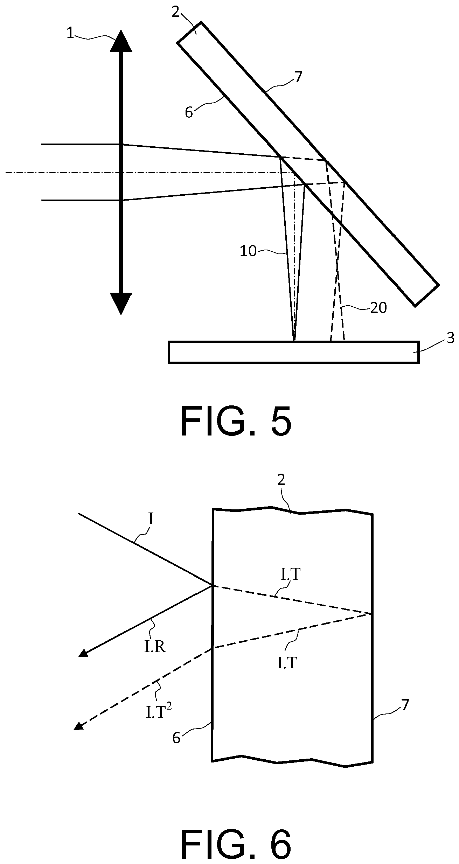

Les deux images doivent avoir des intensités voisines. Comme on le voit sur la figure 4, si I est l'intensité de l'image sans la lame optique et si on prend comme hypothèse que les faces de la lame optique ont les mêmes coefficients de transmission T et de réflexion R, on démontre facilement que la première image a une intensité $I.T^2$ et la seconde image a une intensité $I.T^2R^2$. Sur les figures 4 et 6, seul le parcours d'un rayon lumineux est représenté.

Dans une variante représentée sur les figures 5 et 6, il est également possible d'utiliser la lame optique 2 selon l'invention en réflexion. Dans ce cas, la lame optique 2 est un miroir de Mangin, c'est-à-dire une lame optique comportant une première face semi-réfléchissante 6 et une seconde face réfléchissante 7, la première image 10 étant obtenue par réflexion sur la première face semi-réfléchissante 6, la seconde image 20 étant obtenue par réflexion sur la seconde face réfléchissante 7.

Les deux images doivent avoir des intensités voisines. Comme on le voit sur la figure 6, si I est l'intensité de l'image sans la lame optique, si la première face 6 de la lame optique a T comme coefficient de transmission et R comme coefficient de réflexion et si la seconde face 7 est parfaitement réfléchissante, on démontre facilement que la première image a une intensité $I.R$ et la seconde image a une intensité $I.T^2$. Il est alors facile d'égaliser les intensités des deux images.

## Revendications

1. Instrument d'optique comprenant au moins :

   une architecture optique comprenant un ensemble optique (1) destiné à faire d'un objet lumineux une image, et un ensemble de photoréception (3) et des moyens d'acquisition et d'analyse de ladite image, lesdits moyens d'acquisition et d'analyse comportant un algorithme de type diversité de phase,
   **caractérisé en ce que** l'architecture optique comporte une lame optique (2) de puissance optique faible ou nulle disposée au voisinage de l'ensemble de photoréception et agencée de façon à former sur tout ou partie dudit ensemble une première image focalisée et une seconde image défocalisée d'une première valeur prédéterminée et décalée d'une seconde valeur prédéterminée par rapport à la première image.

2. Instrument d'optique selon la revendication 1, **caractérisé en ce que**, l'instrument ayant un axe optique (X-X), la lame optique (2) est une lame à faces (4, 5) planes, parallèles entre elles et perpendiculaires à l'axe optique, la première image étant obtenue en transmission simple à travers ladite lame optique, la seconde image étant obtenue en transmission après double réflexion sur les deux faces de la lame.

3. Instrument d'optique selon la revendication 2, **caractérisé en ce que** la lame optique (2) est située au bord de l'ensemble de photoréception (3).

4. Instrument d'optique selon la revendication 1, **caractérisé en ce que**, l'instrument ayant un axe optique (X-X), la lame optique (2) est une lame à faces (4, 5) planes et parallèles inclinée sur l'axe optique, la première image étant obtenue en transmission simple à travers ladite lame optique, la seconde image étant obtenue en transmission après double réflexion sur les deux faces de la lame.

5. Instrument d'optique selon la revendication 1, **caractérisé en ce que** la lame optique (2) est un prisme à faces (4, 5) planes, la première image étant obtenue en transmission simple à travers ledit prisme, la seconde image étant obtenue en transmission après double réflexion sur les deux faces dudit prisme.

6. Instrument d'optique selon la revendication 1, **caractérisé en ce que** la lame optique (2) est une lame d'air dont les faces sont d'une part la face d'entrée de l'ensemble de photoréception et d'autre part une des faces d'une fenêtre de protection disposée devant ledit ensemble de photoréception, la première image étant obtenue en transmission simple à travers ladite fenêtre de protection, la seconde image étant obtenue en transmission après double réflexion sur la face d'entrée de l'ensemble de photoréception et sur la face de la fenêtre de protection.

7. Instrument d'optique selon la revendication 1, **caractérisé en ce que** la lame optique (2) est un miroir de Mangin, c'est-à-dire une lame optique comportant une première face semi-réfléchissante (6) et une seconde face réfléchissante (7), la première image étant obtenue par réflexion sur la première face semi-réfléchissante, la seconde image étant obtenue par réflexion sur la seconde face réfléchissante.

8. Instrument d'optique selon l'une des revendications précédentes, **caractérisé en ce que** la lame optique (2) comporte un ou deux traitements réfléchissants de façon que l'amplitude de la première image focalisée soit du même ordre de grandeur que l'amplitude de la seconde image défocalisée.

9. Instrument d'optique selon l'une des revendications précédentes, **caractérisé en ce que** l'instrument d'optique est un télescope spatial.


**Patentansprüche**

1. Optisches Instrument, mindestens Folgendes beinhaltend:

    einen optischen Aufbau, beinhaltend eine optische Anordnung (1), welche dazu bestimmt ist, aus einem Lichtobjekt ein Bild zu machen, und
    eine Lichterfassungsanordnung (3) und Mittel zum Erfassen und Analysieren des Bildes, wobei die Mittel zum Erfassen und Analysieren einen Phasendiversitäts-Algorithmus beinhalten,
    **dadurch gekennzeichnet, dass** der optische Aufbau eine optische Platte (2) mit geringer oder null optischer Leistung beinhaltet, welche in der Nähe der Lichterfassungsanordnung bereitgestellt und so angeordnet ist, dass sie an einem Teil oder der gesamten Anordnung ein erstes fokussiertes Bild bildet und ein zweites, um einen ersten vorbestimmten Wert defokussiertes Bild bildet und welches gegenüber dem ersten Bild um einen zweiten vorbestimmten Wert versetzt ist.

2. Optisches Instrument nach Anspruch 1, **dadurch gekennzeichnet, dass**, da das Instrument eine optische Achse (X-X) aufweist, die optische Platte (2) eine Platte mit ebenen Seiten (4, 5) ist, welche parallel zueinander und rechtwinklig zur optischen Achse sind, wobei das erste Bild durch einfache Transmission durch die optische Platte erzielt wird, wobei das zweite Bild durch Transmission nach doppelter Reflexion an den beiden Seiten der Platte erzielt wird.

3. Optisches Instrument nach Anspruch 2, **dadurch gekennzeichnet, dass** die optische Platte (2) am Rand der Lichterfassungsanordnung (3) befindlich ist.

4. Optisches Instrument nach Anspruch 1, **dadurch gekennzeichnet, dass**, da das Instrument eine optische Achse (X-X) aufweist, die optische Platte (2) eine Platte mit ebenen parallelen Seiten (4, 5) ist, welche in Bezug auf die optische Achse geneigt ist, wobei das erste Bild durch einfache Transmission durch die optische Platte erzielt wird, wobei das zweite Bild durch Transmission nach doppelter Reflexion an den beiden Seiten der Platte erzielt wird.

5. Optisches Instrument nach Anspruch 1, **dadurch gekennzeichnet, dass** die optische Platte (2) ein Prisma mit ebenen Seiten (4, 5) ist, wobei das erste Bild durch einfache Transmission durch das Prisma erzielt wird, wobei das zweite Bild durch Transmission nach doppelter Reflexion an den beiden Seiten des Prismas erzielt wird.

6. Optisches Instrument nach Anspruch 1, **dadurch gekennzeichnet, dass** die optische Platte (2) ein Luftspalt ist, dessen Seiten einerseits die Eingangsseite der Lichterfassungsanordnung und andererseits eine der Seiten eines Schutzfensters sind, welches vor der Lichterfassungsanordnung bereitgestellt ist, wobei das erste Bild durch einfache Transmission durch das Schutzfenster erzielt wird, wobei das zweite Bild durch Transmission nach doppelter Reflexion an der Eingangsseite der Lichterfassungsanordnung und an der Seite des Schutzfensters erzielt wird.

7. Optisches Instrument nach Anspruch 1, **dadurch gekennzeichnet, dass** die optische Platte (2) ein Mangin-Spiegel ist, d. h. eine optische Platte, welche eine erste halbreflektierende Seite (6) und eine zweite reflektierende Seite (7) beinhaltet, wobei das erste Bild durch Reflexion an der ersten halbreflektierenden Seite erzielt wird, und wobei das zweite Bild durch Reflexion an der zweiten halbreflektierenden Seite erzielt wird.

8. Optisches Instrument nach einem der vorhergehenden Ansprüche, **dadurch gekennzeichnet, dass** die optische Platte (2) eine oder zwei Reflexionsbehandlungen beinhaltet, sodass die Amplitude des ersten fokussierten Bildes eine Amplitude gleicher Größenordnung wie die Amplitude des zweiten defokussierten Bildes ist.

9. Optisches Instrument nach einem der vorhergehenden Ansprüche, **dadurch gekennzeichnet, dass** das Instrument ein Raumteleskop ist.

**Claims**

1. Optical instrument comprising at least:

   an optical architecture comprising an optical assembly (1) intended to make an image of a luminous object, and a photoreception assembly (3) and means for acquisition and analysis of the said image, the said acquisition and analysis means comprising an algorithm of phase diversity type,
   **characterized in that** the optical architecture comprises an optical plate (2) of low or no optical power arranged in the vicinity of the photoreception assembly and disposed so as to form on all or part of the said assembly a first focused image and a second image defocused by a first predetermined value and shifted by a second predetermined value with respect to the first image.

2. Optical instrument according to claim 1, **characterized in that**, the instrument having an optical axis (X-X), the optical plate (2) is a plate with mutually parallel plane faces (4, 5) perpendicular to the optical axis, the first image being obtained in simple transmission through the said optical plate, the second image being obtained in transmission after double reflection on the two faces of the plate.

3. Optical instrument according to claim 2, **characterized in that** the optical plate (2) is situated at the edge of the photoreception assembly (3).

4. Optical instrument according to claim 1, **characterized in that**, the instrument having an optical axis (X-X), the optical plate (2) is a plate with plane and parallel faces (4, 5) inclined to the optical axis, the first image being obtained in simple transmission through the said optical plate, the second image being obtained in transmission after double reflection on the two faces of the plate.

5. Optical instrument according to claim 1, **characterized in that** the optical plate (2) is a prism with plane faces (4, 5), the first image being obtained in simple transmission through the said prism, the second image being obtained in transmission after double reflection on the two faces of the said prism.

6. Optical instrument according to claim 1, **characterized in that** the optical plate (2) is an air knife whose faces are on the one hand the entrance face of the photoreception assembly and on the other hand one of the faces of a protection window arranged in front of the said photoreception assembly, the first image being obtained in simple transmission through the said protection window, the second image being obtained in transmission after double reflection on the entrance face of the photoreception assembly and on the face of the protection window.

7. Optical instrument according to claim 1, **characterized in that** the optical plate (2) is a Mangin mirror, that is to say an optical plate comprising a first semi-reflecting face (6) and a second reflecting face (7), the first image being obtained by reflection on the first semi-reflecting face, the second image being obtained by reflection on the second reflecting face.

8. Optical instrument according to one of the preceding claims, **characterized in that** the optical plate (2) comprises one or two reflecting treatments such that the amplitude of the first focused image is of the same order of magnitude as the amplitude of the second defocused image.

9. Optical instrument according to one of the preceding claims, **characterized in that** the optic instrument is a space telescope.

FIG. 1

FIG. 2

# FIG. 3

# FIG. 4

FIG. 5

FIG. 6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4309602 A
- US 5598261 A
- US 5610707 A
- US 20040099787 A1
- US 20040056174 A
- FR 2919052
- US 7274442 B
- CN 102564612 A
- CN 102636271 A

**Littérature non-brevet citée dans la description**

- Phase retrieval and diversity in adaptive optics. *Optical Engineering,* 1982, vol. 21
- Joint estimation of object and aberrations by using phase diversity. *Journal of the Optical Society of America A,* 1992, vol. 9, 7
- Hubble space telescope characterized by using phase retrieval algorithms. *Applied Optics,* 1993, vol. 32 (10), 1747-1767
- Wavefront sensing and image restoration from focused and defocused solar images. *Astronomy and Astrophysics,* 1994, vol. 107, 243-264
- Phase retrieval algorithm for JWST flight testbed telescope, Space telescopes and Instrumentation. *SPIE,* 2006, vol. 6265
- **KENDRICK.** Closed-loop wavefront correction using phase diversity. *SPIE 3356 Space Telescopes and Instruments,* 1998, vol. 3356
- Optical wavefront reconstruction: theory and numerical methods. *SIAM review,* 2002, vol. 44 (2), 169-224